# EUROPÄISCHE PATENTSCHRIFT

(11) **EP 2 732 683 B1**
(45) Veröffentlichungstag und Bekanntmachung des Hinweises auf die Patenterteilung: **28.11.2018**
(21) Anmeldenummer: 12723165.2
(22) Anmeldetag: 22.05.2012
(51) Int. Cl.: G02F 1/1333, H05K 5/02, H05K 7/20

(54) **TRÄGER FÜR EIN DISPLAYMODUL UND ANZEIGEVORRICHTUNG MIT EINEM DERARTIGEN TRÄGER**
CARRIER FOR A DISPLAY MODULE AND DISPLAY APPARATUS HAVING SUCH A CARRIER
SUPPORT DE MODULE AFFICHEUR ET DISPOSITIF D'AFFICHAGE COMPRENANT UN TEL SUPPORT

(30) Priorität: 15.07.2011 DE 102011079216
(43) Veröffentlichungstag der Anmeldung: 21.05.2014
(73) Patentinhaber: Robert Bosch GmbH, 70442 Stuttgart (DE)
(72) Erfinder: KAEFER, Stefan, 70469 Stuttgart (DE); BURKHARDT, Volker, 71139 Ehningen (DE)
(86) Internationale Anmeldenummer: PCT/EP2012/059422
(87) Internationale Veröffentlichungsnummer: WO 2013/010695

(56) Entgegenhaltungen:
- JP-A- 2003 173 147

## Beschreibung

Die vorliegende Erfindung betrifft einen Träger für ein Displaymodul nach dem Oberbegriff von Anspruch 1. Der Träger weist Mittel zur Aufnahme und/oder Befestigung eines Displaymoduls sowie eine Lufteinlass-Öffnung und mindestens eine Luftauslass-Öffnung auf. Diese beiden Öffnungen sind durch Luftkanäle miteinander verbunden, welche zum Kühlen des Displaymoduls von Kühlluft durchströmt werden können. Ferner betrifft die Erfindung eine Anzeigevorrichtung, die einen derartigen Träger und ein davon getragenes Displaymodul umfasst.

### Stand der Technik

Träger dieser Art werden insbesondere für LED-Displaymodule verwendet, die beispielsweise als LED-Backlight-Display ausgeführt sein können. LEDs (LED = Light Emitting Diode) haben eine hohe Lebensdauer, eine geringere Baugröße sowie einen guten Wirkungsgrad bei der Umwandlung elektrischer Energie in Licht. Ferner zeichnen sich LEDs durch eine Unempfindlichkeit gegenüber Stößen und Erschütterungen aus, was insbesondere bei der Anwendung im Kraftfahrzeug-Bereich einen erheblichen Vorteil darstellt.

Dennoch muss vor dem Hintergrund einer ständig fortschreitenden Leistungssteigerung und der hiermit einhergehenden hohen Leistungsaufnahme bei LEDs die als Verlust auftretende Abwärme abgeführt werden, um eine Überhitzung und damit eine Funktionsbeeinträchtigung oder sogar eine Zerstörung der LEDs zu verhindern. Auch die Displaypanels der Displaymodule sind wärmeempfindlich. Durch die Einwirkung von Wärme kann sich ihre Anzeigecharakteristik ändern und die Lebensdauer verkürzt werden.

Zur Ableitung der beim Betrieb von Display-Modulen entstehenden Verlustwärme sind verschiedene Konstruktionen bekannt. Üblicherweise wird die Abwärme von LED-Bauelementen an einen metallischen Kühlkörper abgeführt. So ist es bei Display-Modulen bekannt, die an den LEDs entstehende Wärme direkt über das Displaygehäuse abzuführen. Das meist aus Stahl oder Aluminiumblech bestehende Displaygehäuse dient hierbei als Wärmesenke.

Auch ist es bekannt, die Wärme über sogenannte Heatpipes an externe Kühlkörper abzuführen.

Aus der US 2004/0100769 A1 ist eine Kühlvorrichtung für Lichtventile bekannt. Lichtventile, die beispielsweise als elektrisch steuerbares Beugungsgitter zur Bilderzeugung bei Projektoren und Monitoren zum Einsatz kommen können, sind hier mittels eines Trägerrahmens auf einer Seite einer Leiterplatte befestigt. Auf der anderen Seite der Leiterplatte ist eine Kühleinrichtung mit einer Grundplatte vorgesehen, von der sich ein Vorsprung durch eine Öffnung in der Leiterplatte hindurch zum Lichtventil erstreckt, um dessen Verlustwärme aufzunehmen. Auf der Rückseite der Grundplatte der Kühleinrichtung ist eine Vielzahl von parallel zueinander angeordneten Kühlrippen vorgesehen, die einen Lüfter umgeben. Durch den Lüfter wird ein Luftstrom erzeugt, der zur Abführung der Wärme an den Kühlrippen vorbeiströmt.

Ein Träger für ein Displaymodul der eingangs genannten Art ist aus der JP-2003173147 A bekannt. Dabei ist ein Displaymodul in einem Gehäuse aufgenommen, welches insofern als Träger fungiert. Das Gehäuse hat eine Lufteinlass-Öffnung und eine Luftauslass-Öffnung, durch die ein Luftstrom zur Kühlung des Displays und zur Abfuhr von Wärme durch das Gehäuse geführt werden kann. Dabei wird der Luftstrom in dem Gehäuse durch einen Luftkanal gelenkt, der zwischen einer Leiterplatte und an der Rückseite des Displaymoduls vorgesehenen Verstärkungsrippen ausgebildet ist.

Aufgabe der vorliegenden Erfindung ist es, einen Träger für ein Displaymodul vorzuschlagen, der bei einfacher Konstruktion eine effiziente und gleichmäßige Kühlung auch von größeren Displaymodulen ermöglicht. Außerdem soll eine Anzeigevorrichtung mit einem Displaymodul geschaffen werden, die sich durch eine hohe Lebensdauer auszeichnet.

### Offenbarung der Erfindung

Die Aufgabe wird durch einen Träger für ein Displaymodul nach Anspruch 1 gelöst. Ferner wird die Aufgabe durch eine Anzeigevorrichtung mit den Merkmalen des Anspruchs 10 gelöst.

Die der vorliegenden Erfindung zugrundeliegende Idee besteht darin, dass der Träger eine zentrale Lufteinlass-Öffnung und mindestens zwei Luftauslass-Öffnungen, die an verschiedenen Stellen des Trägers angeordnet sind, aufweist, wobei die Lufteinlass-Öffnung mit den Luftauslass-Öffnungen über Luftkanäle verbunden ist, die zwischen Rippen ausgebildet sind, welche an dem Träger vorgesehen sind.

Wesentlicher Grundgedanke der Erfindung ist es dabei, dass ein durch eine Einlass-Öffnung zugeführter Luftstrom aufgeteilt und zu mehreren Auslass-Öffnungen verteilt wird. Auf diese Weise können auch großflächige Displaymodule gleichmäßig und besonders wirksam gekühlt werden. Da nur ein einziger Luftstrom durch eine zentrale Lufteinlass-Öffnung eingespeist werden muss, kann die Kühlung zudem kostengünstiger erreicht werden, als bei einer großflächigen Zufuhr von Kühlluft.

Auch werden für die Wärmeabfuhr keine zusätzlichen Teile, etwa heatpipes benötigt, wodurch der Aufwand und die Kosten gering ausfallen.

Insgesamt wird so auf konstruktiv besonders einfache Weise eine hocheffiziente Kühlung eines in den erfindungsgemäßen Träger einzusetzenden Displaymoduls erzielt.

Außerdem erlaubt die zentrale Luftzufuhr eine Reduzierung des benötigten Bauraums, was gerade im Automobilbereich einen weiteren wesentlichen Vorteil darstellt.
Besonders vorteilhaft ist es, wenn die zentrale Lufteinlass-Öffnung über Luftkanäle mit einer Vielzahl von Luftauslass-Öffnungen verbunden ist, die an der Oberseite des Trägers und zumindest an den beiden entgegengesetzt liegenden Seiten des Trägers angeordnet sind. Zusätzlich können auch an der Unterseite des Trägers weitere Luftauslass-Öffnungen vorgesehen sein. Hierdurch ist eine besonders gute Verteilung der Kühlluft über die Fläche des aufzunehmenden Displays erreichbar.

Vorzugsweise sind zumindest einzelne Luftauslass-Öffnungen derart am Träger angeordnet, dass ein eine Luftauslass-Öffnung durchströmender Luftstrom in einer parallel zum aufzunehmenden Displaymodul liegenden Ebene strömt. Auf diese Weise werden Umlenkungen des Luftstroms im Bereich der Auslass-Öffnungen vermieden, was eine strömungstechnisch günstige Bauform mit geringen Verlusten und einem geräuscharmen Betrieb gestattet.

Besonders vorteilhaft ist es ferner, wenn nur eine einzige zentrale Lufteinlass-Öffnung vorgesehen ist, die sich mittig in einem unteren Bereich des Trägers befindet. Vorteilhafterweise hat die Lufteinlass-Öffnung dabei einen rechteckigen Öffnungsquerschnitt.

Günstig ist es dabei, wenn die Lufteinlass-Öffnung derart am Träger angeordnet ist, dass sie senkrecht zur Ebene eines aufzunehmenden Displaymoduls von dem zugeführten Luftstrom durchströmt wird.

Gemäß einer besonders bevorzugten Ausführungsform verlaufen die Rippen, die zwischen sich die Luftkanäle für die Kühlluft ausbilden, bezogen auf einen zentralen Punkt der Lufteinlass-Öffnung zumindest annähernd radial. Auf diese Weise erstrecken sich die Kühlluftkanäle fächerförmig von einem punktuellen Lufteinlass nach außen, was eine besonders gleichmäßige Verteilung der Kühlluft von dem zentralen Lufteinlass über die gesamte Fläche eines aufzunehmenden Displaymoduls ermöglicht.

Außerdem erhöht eine radiale Anordnung von Kühlrippen wesentlich die Steifigkeit des Trägers und somit auch die Stabilität einer hiermit ausgestatteten Anzeigevorrichtung, was sich positiv auf die sogenannte Mura-Bildung auswirkt (optische Fehler bzw. Bildfehler auf dem Display, vor allem Bildfehler aufgrund einer ungleichmäßig verteilten Flüssigkristallschicht im Display-Panel, werden im englischen Sprachgebrauch als Mura-Erscheinung bezeichnet). Insbesondere bei IPS-Displays (IPS = In-Plane-Switching), die aufgrund ihrer hohen Bildqualität zunehmend eingesetzt werden, führt eine Torsion bzw. Verspannung des Displays zu einer sogenannter Black-Murabildung auf dem Display, d.h. zu störenden hellen wolkigen Bereichen bei dunklen Darstellungen. Derartige Bildstörungen können durch eine steifere Bauform des Trägers wirkungsvoll reduziert werden, was einen weiteren Vorteil der radialen Anordnung der Rippen darstellt.

Besonders vorteilhaft ist es, wenn die Rippen auf der dem aufzunehmenden Displaymodul zugewandten Vorderseite des Trägers angeordnet sind, so dass die Kühlluft unmittelbar an der Rückseite eines Displaymoduls entlang strömen kann. Wenn dabei ergänzend zumindest annähernd senkrecht verlaufende Kühlrippen auf der von dem aufzunehmenden Displaymodul abgewandten Rückseite des Trägers vorgesehen sind, kann eine Zwangskonvektion herbeigeführt werden, die eine zusätzliche Kühlung des Trägers bewirkt. Wenn diese Kühlung über die Zwangskonvektion bei einer geringeren thermischen Belastung, etwa bei geringer Umgebungstemperatur und/oder bei einem beispielsweise nachts gedimmten Display, ausreichend ist, kann die durch einen Lüfter herbeigeführte aktive Kühlung gedrosselt oder sogar abgeschaltet werden. Etwaige Störgeräusche durch den Lüfter sowie die Leistungsaufnahme des Lüfters können hierdurch minimiert werden.

Vorzugsweise besteht der Träger aus einer Leichtmetalllegierung, insbesondere aus einer Magnesiumlegierung. Aufgrund der geringen spezifischen Masse kann so das Gesamtgewicht einer mit dem erfindungsgemäßen Träger ausgestatteten Anzeigevorrichtung besonders klein gehalten werden. Außerdem besitzt Magnesium eine gute Wärmeleitfähigkeit sowie eine gute elektrische Leitfähigkeit, was sich positiv auf die Entwärmung und auf die elektromagnetische Verträglichkeit (EMV-Eigenschaften) der Anzeigevorrichtung auswirkt.

Fehler in der Bilddarstellung des Displays, insbesondere Murabildungen können weiterhin dadurch verhindert oder reduziert werden, dass die Anlageflächen des Trägers, die in Kontakt mit dem aufzunehmenden Displaymodul kommen, spanabhebend bearbeitet, vorzugsweise gefräst sind. Hierdurch sind sehr genaue und ebene Flächen mit einer hohen Oberflächengüte erzielbar, die einen möglichen Verzug des Displaymoduls beim Verschrauben mit dem Träger verringern und gleichzeitig einen geringen Wärmeübergangswiderstand zwischen Display und Träger und somit eine gute Wärmeabfuhr gestatten.

Die vorliegende Erfindung betrifft ferner eine Anzeigevorrichtung, insbesondere eine Anzeigevorrichtung für ein Kraftfahrzeug, die einen Träger der vorangehend beschriebenen Art mit einem davon getragenen Displaymodul aufweist. Aufgrund der durch die Bauweise des Trägers erreichten effizienten und gleichmäßigen Kühlung des Displaymoduls können Funktionsbeeinträchtigungen oder Zerstörungen des Panels und der Lichtquellen, insbesondere der LEDs des Displaymoduls aufgrund von Überhitzungen vermieden oder zumindest verringert werden, so dass die Lebensdauer der Anzeigevorrichtung erhöht wird.

Vorzugsweise ist das Displaymodul dabei mittels Schrauben an dem Träger befestigt, was die Gesamtsteifigkeit der Anzeigevorrichtung wesentlich erhöht und sich somit positiv auf die Bildqualität bzw. eine mögliche Murabildung des Displays auswirkt.

Vorteilhafterweise sind der Träger und die daran anliegende Rückwand des Displaymoduls aus demselben oder zumindest aus einem sehr ähnlichen Material hergestellt, wodurch mechanische Spannungen zwischen den Bauteilen aufgrund unterschiedlicher Wärmedehnungen vermieden werden, was sich ebenfalls positiv bei der Bildqualität bemerkbar macht.

Besonders vorteilhaft ist es, wenn eine vorzugsweise flexible Leiterplatte (FPC = Flexible Printed Circuit), über die die elektrischen Signale an das Displaypanel übertragen werden, an der Rückseite des Displaymoduls fixiert, insbesondere angeklebt ist. Auf diese Weise können mechanische Belastungen der Leiterplatte bzw. des FPCs, die beispielsweise durch Zugbelastungen hervorgerufen werden können, und somit auch mechanische Belastung des Displaypanels und damit einhergehende Bildverschlechterungen, etwa durch Murabildung verhindert werden. Gleichzeitig wird durch die Fixierung verhindert, dass das FPC seine Position bzw. Lage ändert und dadurch die Kühlluftzirkulation in der Anzeigevorrichtung behindert.

Um genügend Platz für die Leiterplatte oder für das FPC zu schaffen, können die Rückseite des Displaymoduls und/oder die dem Displaymodul zugewandten Rippen im Bereich der Leiterplatte bzw. des FPCs vertieft sein. Beschädigungen der Leiterplatte durch Berührungen mit den Rippen des Trägers können so vermieden werden.

Die Erfindung wird im folgenden anhand der beiliegenden Zeichnungen beispielhaft näher erläutert. Es zeigen:
- Figur 1:: dreidimensionale Ansicht eines erfindungsgemäßen Trägers;
- Figur 2:: Vorderansicht des Trägers aus Figur 1;
- Figur 3:: Rückansicht des Trägers aus Figur 1;
- Figur 4:: dreidimensionale Ansicht einer erfindungsgemäßen Anzeigevorrichtung; und
- Figur 5:: eine Explosions-Zeichnung der Anzeigevorrichtung aus Figur 4.

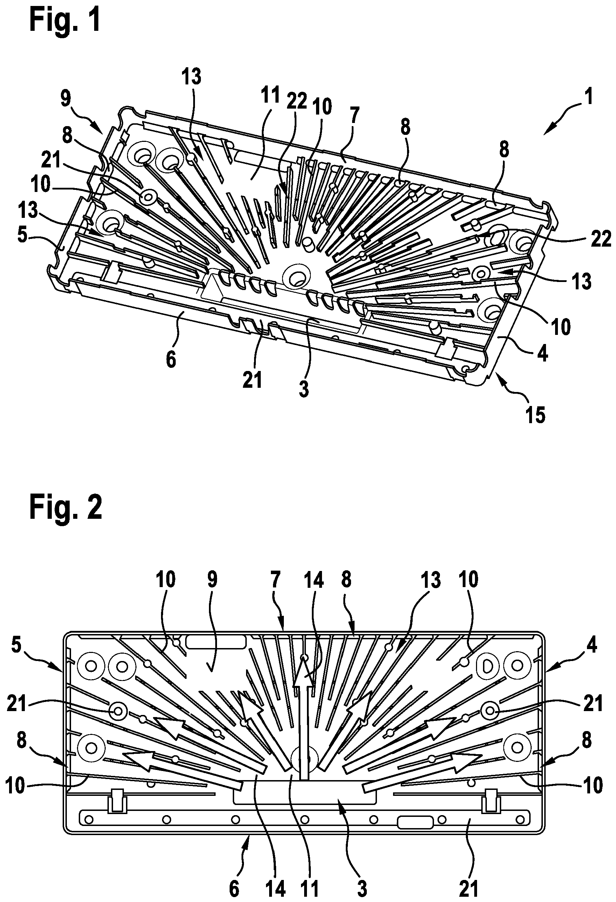

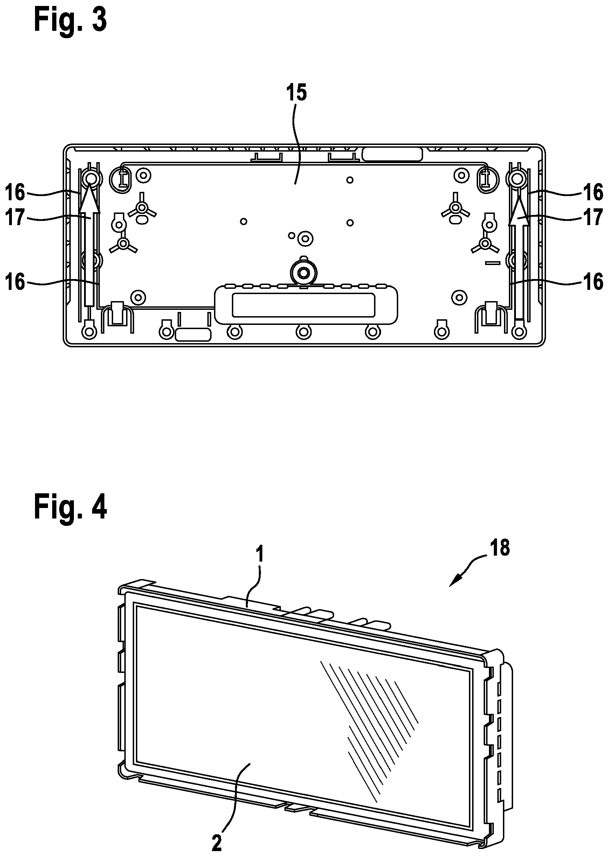

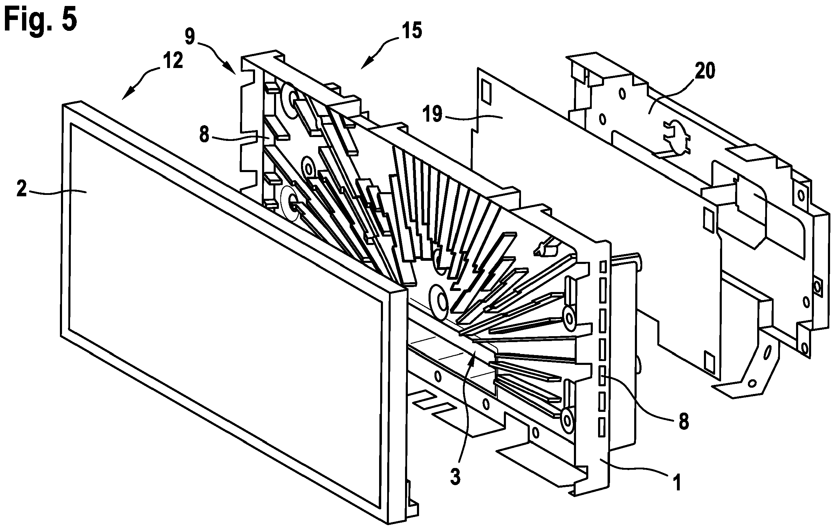

Die Figuren 1 bis 3 zeigen ein Beispiel eines erfindungsgemäßen Trägers 1, in dem ein in Figur 5 dargestelltes Displaymodul 2 aufgenommen werden kann. Der Träger 1 hat nur eine einzige zentrale Lufteinlass-Öffnung 3, die hier mit einem rechteckigen Querschnitt mittig zwischen der rechten Seite 4 und der linken Seite 5 sowie nahe der Unterseite 6 des Trägers 1 angeordnet ist. Die Lufteinlass-Öffnung 3 liegt dabei in der Haupterstreckungsebene des Trägers 1, die parallel zur Zeichnungsebene von Figur 2 und 3 liegt, so dass ein die Lufteinlass-Öffnung 3 durchströmender Luftstrom senkrecht zur Ebene des aufzunehmenden Displaymoduls 2 verläuft.

An der Oberseite 7 sowie an der rechten und linken Seite 4, 5 des Trägers 1 sind eine Vielzahl von Luftauslass-Öffnungen 8 angeordnet, die an verschiedenen Stellen des Trägers 1 jeweils in einer parallel zum aufzunehmenden Displaymodul 2 liegenden Ebene von einem Teil des durch die Öffnung 3 eingelassenen Luftstroms durchströmt werden.
Dazu sind auf der dem aufzunehmenden Displaymodul 2 zugewandten Vorderseite 9 des Trägers 1 mehrere Kühlrippen 10 ausgeformt, die sich ausgehend von einem zentralen Punkt der Lufteinlass-Öffnung 3 radial nach außen erstrecken. Die einstückig mit dem Träger 1 gefertigten Kühlrippen 10 bilden zwischen sich sowie zwischen der Grundfläche 11 des Trägers 1 und der Rückwand 12 des aufzunehmenden Displaymoduls 2 mehrere Luftkanäle 13 aus, die jeweils von einem Teil des zugeführten Luftstroms durchströmt werden, was durch die Pfeile 14 in Figur 2 symbolisiert ist. Die Luftkanäle 13 decken dabei in fächerförmiger Anordnung die gesamte Fläche des aufzunehmenden Displaymoduls 2 ab, was eine besonders gleichmäßige und wirksame Kühlung des Displaymoduls 2 erlaubt.

Darüber hinaus sind hier auf der von dem aufzunehmenden Displaymodul 2 abgewandten Rückseite 15 des Trägers 1 einige parallel zueinander angeordnete und senkrecht verlaufende Kühlrippen 16 vorgesehen, die zusätzlich zu einer passiven Kühlung des Trägers 1 durch Zwangskonvektion führen, was durch die Pfeile 17 in Figur 3 symbolisiert ist.

In Figur 4 ist eine für ein Kraftfahrzeug bestimmte Anzeigevorrichtung 18 gezeigt, bei der ein hier mit LED-Backlight ausgeführtes Displaymodul 2 in dem Träger 1 aufgenommen ist. Wie in Figur 5 dargestellt umfasst die Anzeigevorrichtung 18 außerdem eine auf der Rückseite 15 des Trägers 1 angeordnete Leiterplatte 19, die von einem Rückdeckel 20 abgedeckt ist.

Das Displaymodul 2 ist mittels Schrauben am Träger 1 befestigt, wobei die Anlageflächen 21 des Trägers 1, die mit dem Displaymodul 2 in Kontakt kommen, zur Erzielung einer hohen Oberflächengüte gefräst sind, um Fehler in der Bilddarstellung, insbesondere Murabildungen möglichst weitgehend zu reduzieren oder sogar vollständig zu verhindern.

An der Rückwand 12 des Displaymoduls 2 ist in einem streifenförmigen oberen Bereich eine mit der Leiterplatte 18 elektrisch verbundene, hier nicht näher dargestellte, flexible Leiterplatte (FPC) aufgeklebt, über die die Signale für die Bilderzeugung an das Panel des Displaymoduls 2 übertragen werden. Um Beschädigungen der flexiblen Leiterplatte durch die Kühlrippen 10 zu vermeiden, sind diese im Bereich der flexiblen Leiterplatte mit kleinen Vertiefungen 22 ausgeführt.

## Patentansprüche

1. Träger (1) für ein Displaymodul (2), insbesondere für ein LED-Displaymodul, mit Mitteln (21) zur Aufnahme und/oder Befestigung eines Displaymoduls (2) sowie mit einer Lufteinlass-Öffnung (3) und mindestens einer Luftauslass-Öffnung (8), die durch Luftkanäle (13) miteinander verbunden sind, welche zum Kühlen des Displaymoduls (2) von Kühlluft durchströmbar sind,
**dadurch gekennzeichnet,**
**dass** der Träger (1) eine zentrale Lufteinlass-Öffnung (3) aufweist, die über Luftkanäle (13) mit mindestens zwei Luftauslass-Öffnungen (8) verbunden ist, welche an verschiedenen Stellen des Trägers (1) angeordnet sind, wobei die Luftkanäle (13) zwischen an dem Träger (1) vorgesehenen Rippen (10) ausgebildet sind, dass die zentrale Lufteinlass-Öffnung (3) über Luftkanäle (13) mit mehreren Luftauslass-Öffnungen (8) verbunden ist, die an der Oberseite (7) des Trägers (1) und an den beiden entgegengesetzt liegenden Seiten (4, 5) des Trägers (1) angeordnet sind, dass die Rippen (10) bezogen auf einen zentralen Punkt der Lufteinlass-Öffnung (3) zumindest annähernd radial verlaufen, so dass sich die Kühlkanäle (13) fächerförmig von der Lufteinlass-Öffnung (3) nach außen erstrecken und dass die Rippen (10) auf der dem aufzunehmenden Displaymodul (2) zugewandten Vorderseite (9) des Trägers (1) angeordnet sind.

2. Träger (1) nach Anspruch 1, **dadurch gekennzeichnet, dass** die Luftauslass-Öffnungen (8) derart am Träger (1) angeordnet sind, dass ein eine Luftauslass-Öffnung (8) durchströmender Luftstrom in einer Ebene strömt, die parallel zum aufzunehmenden Displaymodul (2) liegt.

3. Träger (1) nach einem der Ansprüche 1 bis 2, **dadurch gekennzeichnet, dass** nur eine einzige zentrale Lufteinlass-Öffnung (3) mittig in einem unteren Bereich des Trägers (1) angeordnet ist, die vorzugsweise einen rechteckigen Öffnungsquerschnitt hat.

4. Träger (1) nach Anspruch 3, **dadurch gekennzeichnet, dass** die Lufteinlass-Öffnung (3) derart am Träger (1) angeordnet ist, dass sie senkrecht zur Ebene des aufzunehmenden Displaymoduls (2) durchströmt wird.

5. Träger (1) nach einem der vorangegangenen Ansprüche, **dadurch gekennzeichnet, dass** auf der von dem aufzunehmenden Displaymodul (2) abgewandten Rückseite (15) des Trägers (1) zusätzliche Kühlrippen (16) vorgesehen sind, die zumindest annähernd senkrecht verlaufen.

6. Träger (1) nach einem der vorangegangenen Ansprüche, **dadurch gekennzeichnet, dass** er aus einer Leichtmetalllegierung, insbesondere aus einer Magnesiumlegierung besteht.

7. Träger (1) nach einem der vorangegangenen Ansprüche, **dadurch gekennzeichnet, dass** die Anlageflächen (21), die in Kontakt mit dem aufzunehmenden Displaymodul (2) kommen, spanabhebend bearbeitet, vorzugsweise gefräst sind.

8. Anzeigevorrichtung (18), insbesondere für ein Kraftfahrzeug, **dadurch gekennzeichnet, dass** sie einen Träger (1) nach einem der vorangegangenen Ansprüche und ein davon getragenes Displaymodul (2) umfasst, welches vorzugsweise mittels Schrauben an dem Träger (1) befestigt ist.

9. Anzeigevorrichtung (18) nach Anspruch 8, **dadurch gekennzeichnet, dass** eine vorzugsweise flexible Leiterplatte an der Rückseite (12) des Displaymoduls (2) fixiert, insbesondere angeklebt ist.

10. Anzeigevorrichtung (18) nach Anspruch 9, **dadurch gekennzeichnet, dass** die Rückseite (12) des Displaymoduls (2) und/oder die dem Displaymodul (2) zugewandten Rippen (10) im Bereich der Leiterplatte vertieft sind.

## Claims

1. Carrier (1) for a display module (2), in particular for an LED display module, comprising means (21) for receiving and/or securing a display module (2) and also comprising an air inlet opening (3) and at least one air outlet opening (8), which air inlet opening and air outlet opening are connected to one another by air ducts (13) through which cooling air can flow in order to cool the display module (2),
**characterized**
**in that** the carrier (1) has a central air inlet opening (3) which is connected via air ducts (13) to at least two air outlet openings (8) which are arranged at different locations on the carrier (1),
wherein the air ducts (13) are formed between ribs (10) which are provided on the carrier (1), in that the central air inlet opening (3) is connected via air ducts (13) to a plurality of air outlet openings (8) which are arranged on the top side (7) of the carrier (1) and on the two opposite sides (4, 5) of the carrier (1), in that the ribs (10) run at least approximately radially with respect to a central point of the air inlet opening (3), so that the cooling ducts (13) extend outward in the form of a fan from the air inlet opening (3) and that the ribs (10) are arranged on the front side (9) of the carrier (1), which front side faces the display module (2) which is to be received.

2. Carrier (1) according to Claim 1, **characterized in that** the air outlet openings (8) are arranged on the carrier (1) in such a way that an air flow which flows through an air outlet opening (8) flows in a plane which is situated parallel to the display module (2) which is to be received.

3. Carrier (1) according to either of Claims 1 and 2, **characterized in that** only one single central air inlet opening (3) is arranged centrally in a lower region of the carrier (1) and preferably has a rectangular opening cross section.

4. Carrier (1) according to Claim 3, **characterized in that** the air inlet opening (3) is arranged on the carrier (1) in such a way that air flows through the said air inlet opening perpendicular to the plane of the display module (2) which is to be received.

5. Carrier (1) according to one of the preceding claims, **characterized in that** additional cooling ribs (16) which run at least approximately perpendicularly are provided on the rear side (15) of the carrier (1), which rear side is averted from the display module (2) which is to be received.

6. Carrier (1) according to one of the preceding claims, **characterized in that** it is composed of a light metal alloy, in particular of a magnesium alloy.

7. Carrier (1) according to one of the preceding claims, **characterized in that** the contact faces (21) which come into contact with the display module (2) which is to be received are machined, preferably milled.

8. Display apparatus (18), in particular for a motor vehicle, **characterized in that** the said display apparatus comprises a carrier (1) according to one of the preceding claims and a display module (2) which is carried by the said carrier and is preferably secured to the carrier (1) by means of screws.

9. Display apparatus (18) according to Claim 8, **characterized in that** a preferably flexible printed circuit board is fixed, in particular adhesively bonded, to the rear side (12) of the display module (2).

10. Display apparatus (18) according to Claim 9, **characterized in that** the rear side (12) of the display module (2) and/or the ribs (10) which face the display module (2) are/is recessed in the region of the printed circuit board.

## Revendications

1. Élément porteur (1) pour un module d'affichage (2), notamment pour un module d'affichage à LED, comprenant des moyens (21) servant à accueillir et/ou à fixer un module d'affichage (2) et comprenant aussi une ouverture d'entrée d'air (3) et au moins une ouverture de sortie d'air (8), lesquelles sont reliées les unes aux autres par des conduits d'air (13) à travers lesquels peut s'écouler de l'air frais en vue de refroidir le module d'affichage (2),
**caractérisé en ce que**
l'élément porteur (1) possède une ouverture d'entrée d'air (3) centrale qui est reliée à au moins deux ouvertures de sortie d'air (8) par des conduits d'air (13), lesquelles sont disposées à des endroits différents de l'élément porteur (1),
les conduits d'air (13) étant formés entre des ailettes (10) présentes sur l'élément porteur (1),
**en ce que** l'ouverture d'entrée d'air (3) centrale est reliée à plusieurs ouvertures de sortie d'air (8) par des conduits d'air (13), lesquels sont disposés sur le côté supérieur (7) de l'élément porteur (1) et sur les deux côtés (4, 5) opposés de l'élément porteur (1),
**en ce que** les ailettes (10) s'étendent au moins approximativement dans le sens radial par rapport à un point central de l'ouverture d'entrée d'air (3), de sorte que les conduits de refroidissement (13) s'étendent en forme d'éventail depuis l'ouverture d'entrée d'air (3) vers l'extérieur et
**en ce que** les ailettes (10) sont disposées sur le côté avant (9) de l'élément porteur (1) qui fait face au module d'affichage (2) à accueillir.

2. Élément porteur (1) selon la revendication 1, **caractérisé en ce que** les ouvertures de sortie d'air (8) sont disposées sur l'élément porteur (1) de telle sorte qu'un courant d'air qui s'écoule à travers une ouverture de sortie d'air (8) s'écoule dans un plan qui est parallèle au module d'affichage (2) à accueillir.

3. Élément porteur (1) selon l'une des revendications 1 et 2, **caractérisé en ce qu'**une seule et unique ouverture d'entrée d'air (3) centrale est disposée au centre dans une zone inférieure de l'élément porteur (1), laquelle possède de préférence une section transversale d'ouverture rectangulaire.

4. Élément porteur (1) selon la revendication 3, **caractérisé en ce que** l' ouverture d'entrée d'air (3) est disposée sur l'élément porteur (1) de telle sorte qu'elle est traversée par l'écoulement perpendiculairement au plan du module d'affichage (2) à accueillir.

5. Élément porteur (1) selon l'une des revendications précédentes, **caractérisé en ce que** des ailettes de refroidissement (16) supplémentaires, lesquelles s'étendent au moins approximativement perpendiculairement, se trouvent sur le côté arrière (15) de l'élément porteur (1) à l'opposé du module d'affichage (2) à accueillir.

6. Élément porteur (1) selon l'une des revendications précédentes, **caractérisé en ce qu'**il se compose d'un alliage métallique léger, notamment d'un alliage de magnésium.

7. Élément porteur (1) selon l'une des revendications précédentes, **caractérisé en ce que** les surfaces d'appui (21) qui entrent en contact avec le module d'affichage (2) à accueillir sont usinées par enlèvement de copeaux, de préférence fraisées.

8. Dispositif d'affichage (18), notamment pour un véhicule automobile, **caractérisé en ce qu'**il comporte un élément porteur (1) selon l'une des revendications précédentes et un module d'affichage (2) porté par celui-ci, lequel est de préférence fixé à l'élément porteur (1) au moyen de vis.

9. Dispositif d'affichage (18) selon la revendication 8, **caractérisé en ce qu'**un circuit imprimé de préférence souple est fixé, notamment collé, sur le côté arrière (12) du module d'affichage (2).

10. Dispositif d'affichage (18) selon la revendication 9, **caractérisé en ce que** le côté arrière (12) du module d'affichage (2) et/ou les ailettes (10) faisant face au module d'affichage (2) sont plus profonds dans la zone du circuit imprimé.
